# EUROPEAN PATENT SPECIFICATION

(11) **EP 0 908 958 B1**
(45) Date of publication and mention of the grant of the patent: **12.05.2004**
(21) Application number: 97117465.1
(22) Date of filing: 09.10.1997
(51) Int. Cl.: H01L 31/18, H01L 31/0288, C30B 15/34

(54) **In-situ diffusion of dopant impurities during dendritic web growth of silicon crystal ribbon**
In-situ-Diffusion von Dotierstoffen bei dendritisch vernetztem Wachstum eines kristallinen Siliziumbandes
Diffusion in-situ de dopant durant la croissance en réseau dendritique d'un ruban cristal de silicium

(43) Date of publication of application: 14.04.1999
(73) Proprietor: Ebara Corporation, Tokyo 144-8510 (JP)
(72) Inventor: Bathey, Balakrishnan R., Upper St. Clair, Pennsylvania 15241 (US)
(74) Representative: Altenburg, Udo, Dipl.-Phys.

(56) References cited:
- EP-A- 0 369 574
- FR-A- 2 620 135
- CAMPBELL R B ET AL: "STATUS OF SOLAR CELLS AND MODULES FABRICATED FROM DENDRITIC WEB SILICON" PHOTOVOLTAIC SPECIALISTS CONFERENCE, LAS VEGAS, OCT. 21 - 25, 1985, vol. VOL. 1, no. CONF. 18, 21 October 1985, INSTITUTE OF ELECTRICAL AND ELECTRONICS ENGINEERS, pages 465-469, XP000132031

## Description

This invention relates to the field of solar cells for converting solar energy into electrical energy. More particularly, this invention relates to dendritic web photovoltaic cell technology.

### CROSS-REFERENCE TO PROVISIONAL APPLICATION

Solar cells comprising semiconductor devices employing the photovoltaic effect for converting solar energy into electrical energy have long been known. A known particular type of solar cell is made using the dendritic crystal web growing technique in which a source material, such as silicon, is melted in a furnace and slowly withdrawn using a seed crystal attached to a suiteable mechanical drawing apparatus along a path from the source melt through a furnace exit port to a receiving station. Under suiteable temperature controlled conditions and a proper withdrawal rate, the melt material forms a crystalline web having a dendritic cross-section which cools to a finished crystalline web. This process is more fully described in "Deridritic Web Silicon For Solar Cell Application", R.G. Seidenstecker, Journal of Crystal Growth, 39 (1977) PP. 17-22.

In order to provide the photovoltaic effect, semiconductor junctions must be formed within the crystalline web using a suitable dopant technique. One popular technique employed is the dopant diffusion process in which a dopant material is diffused into the crystalline web via the two inajor web surfaces to provide first and second diffusion layers of opposite conductivity type. Diffusion has been done in the past using a gas diffusion process in which the dopant material is in the form of a gas stream which is permitted to flow past the web surfaces so that ions of the dopant materials can be diffused into the crystalline web material. This process must necessarily be carried out well downstream of the crystalline web formation site, and typically requires a separate diffusion station, which adds complexity to the dendritic solar cell production process. In addition, gaseous diffusion requires separate gas sources (for the dopant materials of opposite conductivity type) and carefully designed and fabricated gas flow paths to prevent the dopant gas streams from escaping to ambient or contaminating other equipment.

The European Patent Application number 89307405, titled "An Improved Method of Fabricating Solar Cells", published on May 23, 1990 under EP-A-0 369 574, discloses "a method and apparatus for producing crystalline substrates for use in fabricating solid state electronic devices. A hollow crystalline body is grown from a melt containing a dopant and a P-N junction is formed in said crystalline body as it is being grown. Then the hollow body is severed to provide individual solar cell substrates." Abstract. According to this reference: "An additional primary object of the invention is to provide an improved low cost method of producing crystalline ribbons for use in fabricating solid state electronic devices in which the PN junction is formed during the growth of the crystalline body." Objects of the Invention, column 3, lines 19-23.

### SUMMARY OF THE INVENTION

The invention comprises a method and apparatus for in-situ diffusion of dopant impurities into one or both of the major web surfaces of a growing crystalline web which avoids the disadvantages attendant upon the gas diffusion process, which is relatively uncomplicated to implement in existing melt furnaces and which employs solid dopant diffusion source materials to provide the requisite concentrations of dopant materials.

From a process standpoint, the invention comprises a method of fabricating a dendritic web silicon photovoltaic crystal ribbon according to claim 1.

The web is exposed by placing a solid dopant material, in planar form in a holder adjacent a thermal source to heat the solid dopant material to the diffusion temperature. The thermal source preferably includes a solid thermal element to heat contained in the furnace or heating the thermal element with a heating coil.

The step of exposing the web to the solid dopant material may be performed outside the furnace, the solid dopant material is then placed in thermal contact with the thermal source adjacent the exit port, and the thermal source preferably includes a rapid thermal heater fixture, such as a resistance heater of conventional design.

From an apparatus standpoint, the invention comprises an apparatus for fabricating a dendritic web silicon photovoltaic crystal ribbon according to claim 9. The solid dopant material is preferably received in a holder mounted along the path and located either within the furnace or outside the furnace adjacent the exit port.

The means for heating the solid dopant material includes a thermal element located along the path and at least partially surrounding the dopant material, with the solid dopant material arranged in thermal contact with the thermal element. As optional auxiliary heating coil may be arranged about the thermal element for controlling the temperature. When the heating means is located outside of the furnace, preferably adjacent the exit port, an auxiliary rapid temperature external heater is provided, preferably an electrically powered resistance heater element.

For a fuller understanding of the nature and advantages of the invention, reference should be made to the ensuing detailed description, taken in conjunction with the accompanying drawings.

### BRIEF DESCRIPTION OF THE DRAWINGS

- Fig. 1: is a sectional view of a first embodiment of the invention;
- Fig. 2: is a perspective view partially broken away illustrating a portion of the Fig. 1 embodiment;
- Fig. 3: is a sectional view of a second embodiment of the invention;
- Fig. 4: is a partial perspective view illustrating a portion of the embodiment of Fig. 3;
- Fig. 5: is a sectional view of another embodiment of the invention; and
- Fig. 6: is a perspective view partially broken away of a portion of the embodiment of Fig. 5.

### DETAILED DESCRIPTION OF THE PREFERRED EMBODIMENTS

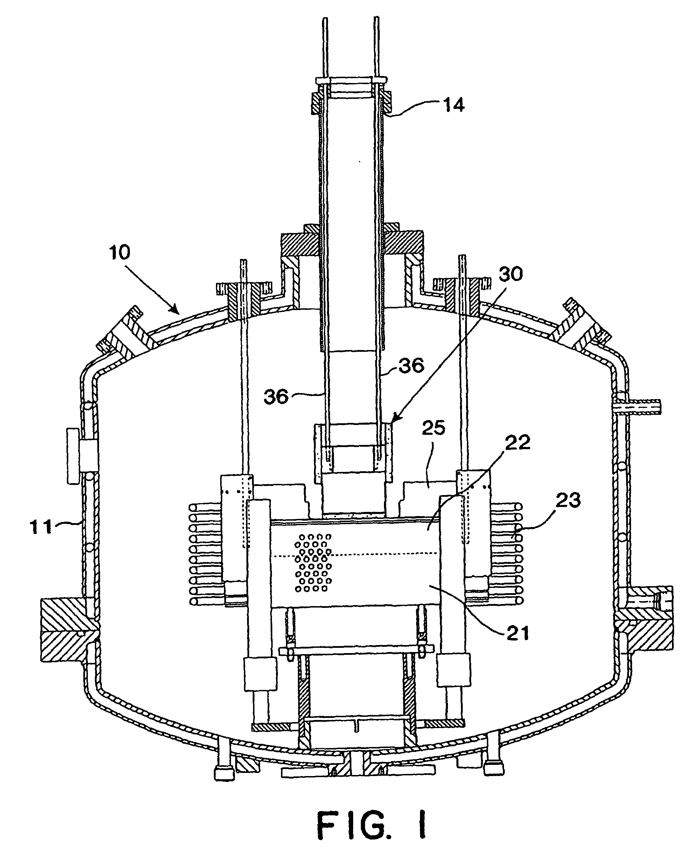

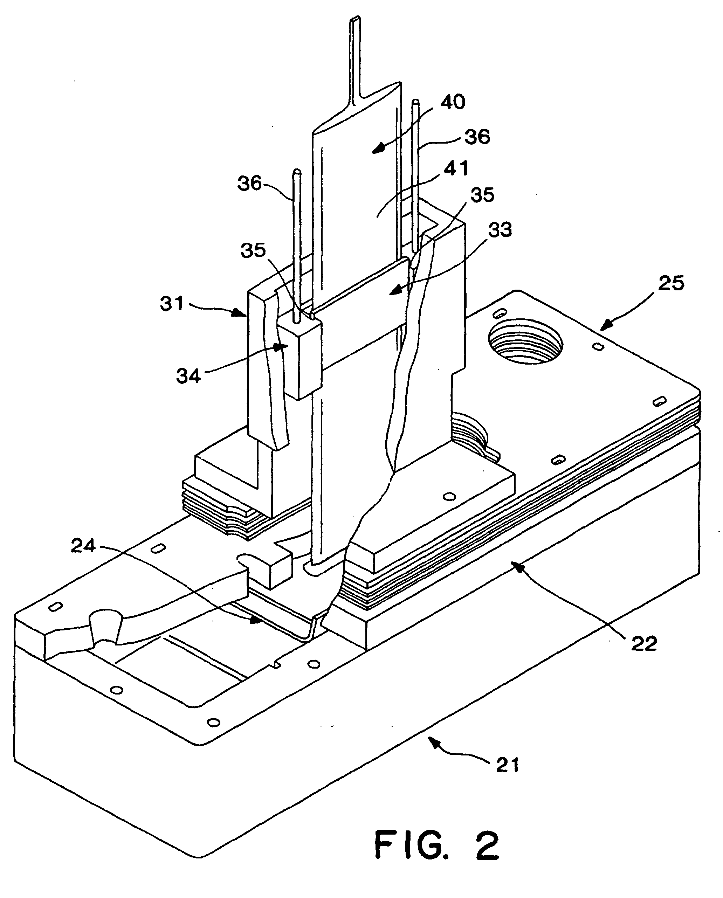

Turning now to the drawings, Figs. 1 and 2 illustrate a first embodiment of the invention in which a vertical thermal element and solid diffusion source and holder are positioned within a web growing furnace. With reference to Fig. 1, a conventional furnace generally designated with reference numeral 10 has an outer wall structure 11 with an exit port 12. Secured to wall structure 11 adjacent exit port 12 is a web drawing support fixture 14 of enabling a growing web initially formed inside the furnace 10 to be withdrawn by means of a conventional web drawing mechanism (not shown) and transferred to a receiving station. Since the web drawing mechanism and receiving station. Since the web drawing mechanism and receiving station are well known, conventional devices, further description is deemed unnecessary in order to avoid prolixity.

Arranged within furnace 10 is a susceptor 21 for retaining a melt crucible (element 24 shown in Fig. 2) in which the melt material (typically silicon) is maintained in a liquid state. An RF heater coil 23 is arranged about susceptor 21 for the purpose of heating the silicon in the crucible in a conventional manner. Arranged above a lid portion 22 of susceptor 21 are a plurality of shields 25. Positioned centrally of shields 25 is an in-situ diffusion fixture and solid diffusion source generally designated with reference numeral 30.

With reference to Fig. 2, which is a perspective view partially broken away of susceptor 21, lid 22, shields 25 and the in-situ diffusion fixture and solid diffusion source 30, element 30 is seen to include a vertical thermal element 31 secured in any suiteable fashion to the top surface of shields 25. Vertical thermal element 31 is preferably fabricated from graphite and serves as a thermal heat source for a solid diffusion source 33 positioned in a diffusion source holder 34. Solid diffusion source 33 is preferably a rectangular strip of diffusion source material, such as phosphorus or boron, and may be mounted in diffusion source holder 34 in any suiteable fashion, such as by forming slots 35 along the inner facing surfaces of the end portions of holder 34. Holder 34 is preferably formed from graphite in order to provide a temperature stable additional heat sink for diffusion source 33. A pair of rods 36 are secured to holder 34 in any suiteable fashion, such as by forming tapped holes extending from the upper surface inwardly of the body of holder 34. Rods 36 extend upwardly of furnace 10 (see Fig. 1) and exit through exit port 12 to a rod manipulating fixture (not shown) in order to enable holder 34 and source 33 to be positioned within and removed from vertical thermal element 31.

Again with reference to Fig. 2, diffusion source 33 is arranged in facing relation with a major surface 41 of growing dendritic web 40 which is drawn upwardly by the web withdrawing mechanism described above. As the growing web passes through the zone of the solid diffusion source 33, dopant ions thermally driven from diffusion source 33 diffuse into the surface and interior of web 40. By controlling the temperature of source 33, the withdrawal rate of web 40, the vertical position of source 33, and the separation distance between source 33 and web 40, diffusion impurity concentrations of desired amounts and depths can be provided within web 40. The withdrawal rate, separation distance between source 33 and web surface 41 and temperature of source 33 are all typically determined empirically. Typical temperature ranges are from about 900°C to about 1000°C. Typical web withdrawal rates are in the range of about 1.5 cm/min. Typical separation distances between source 33 and web surface 41 are in the range of about 100 mils.

While the arrangement shown for the embodiments of Figs. 1 and 2 uses a single planar diffusion source 33 adjacent only one major surface 41 of web 40, a second diffusion source may be positioned within holder 34 in facing relation to the other major surface 42 of growing web 40 in order to provide simultaneous diffusion of dopant impurities into both surfaces of growing web 40.

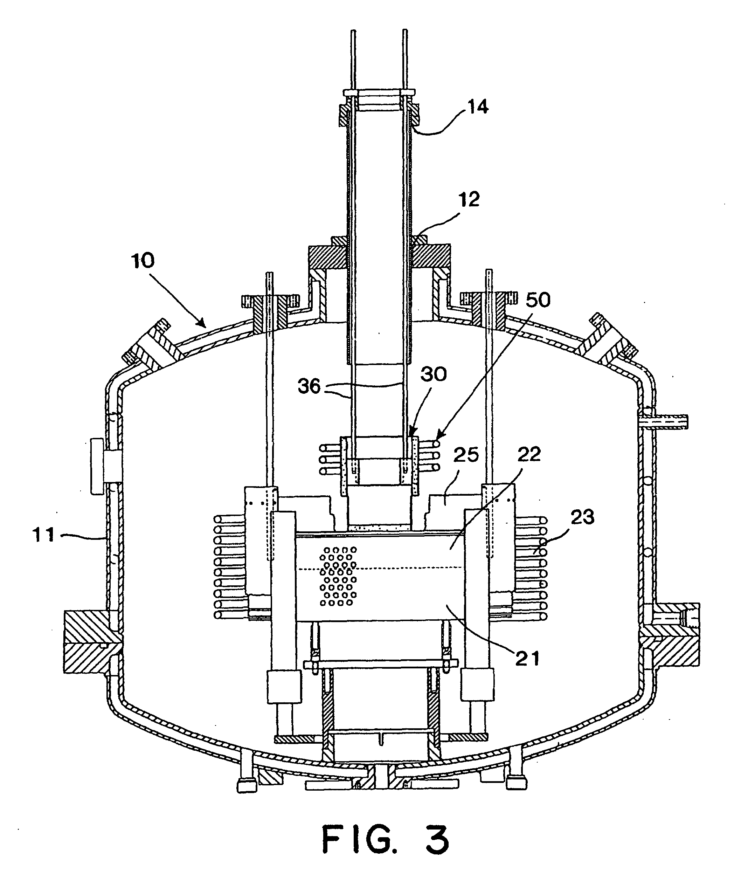

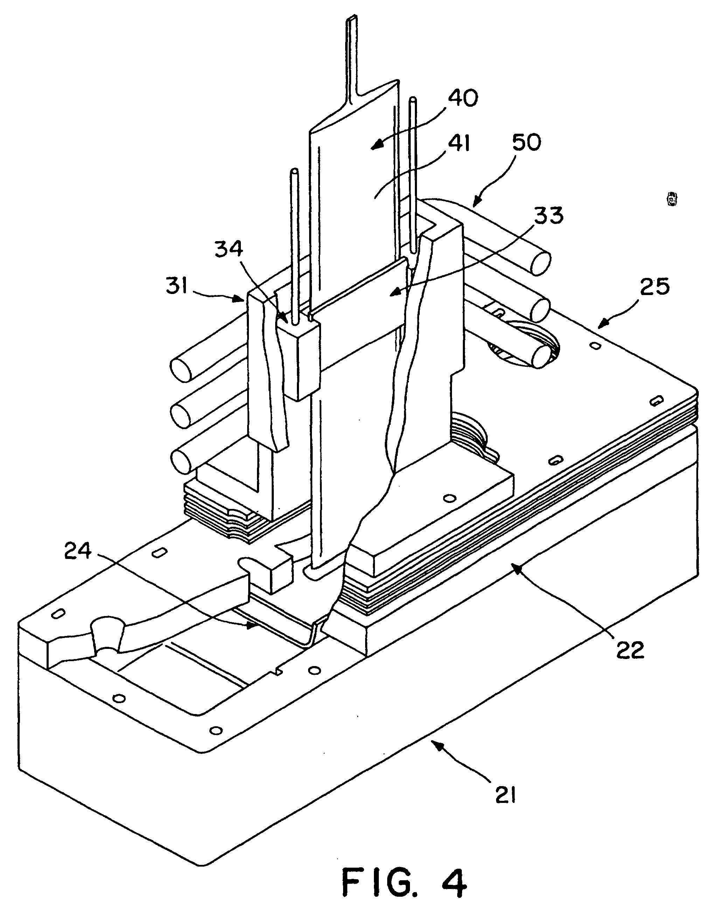

In the embodiment of Figs. 1 and 2, the temperature of vertical thermal element 31, holder 34 and diffusion source 33 is controlled by controlling the furnace temperature, and elements 31, 34 and 33 are heated by thermal conduction through shields 35 and also the ambient temperature within the furnace. The embodiments of Figs. 3 and 4 illustrate a first alternate embodiment in which the temperature of elements 31, 33 and 34 is also controlled by auxiliary heating coils. With reference to Figs. 3 and 4 in which elements common to the embodiment of Figs. 1 and 2 are designated with identical reference numerals, a plurality of RF auxiliary heater coils 50 are arranged about vertical thermal element 31 and are used to provide auxiliary heating for the vertical thermal element 31, holder 34 and solid diffusion source 33. As with the embodiment of Figs. 1 and 2, the Figs. 3 and 4 embodiment may also include a second solid diffusion source positioned facing major surface 42 of growing web 40.

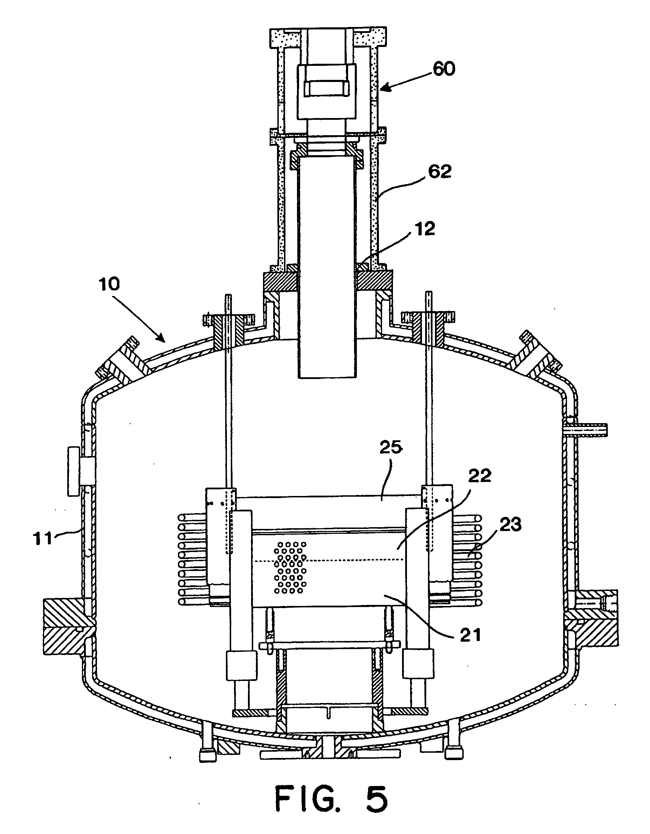

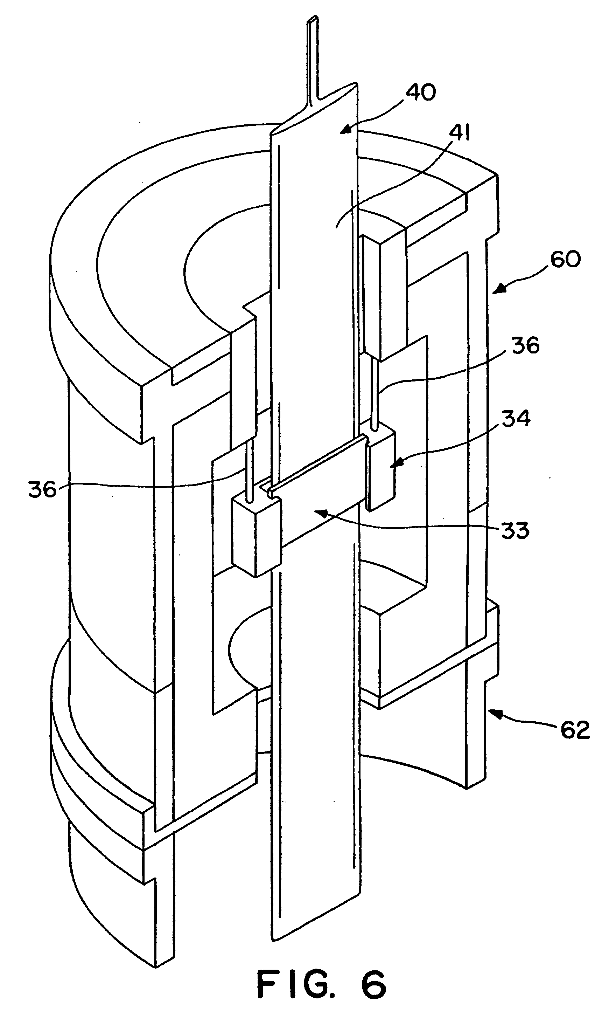

Figs. 5 and 6 illustrate still another alternate embodiment of the invention. In this embodiment, a rapid temperature external heater fixture 60 is mounted on a heater support column 62 outside furnace 10 adjacent exit port 12 to provide auxiliary heating for the growing web. The holder 34 and solid diffusion source 33 are both positioned within the external heater fixture 60, which provides easier access to these elements in order to facilitate installation and removal of the diffusion sources 33. In addition, the embodiment of Figs. 5 and 6 eliminates vertical thermal element 31.

Attached as Appendix A are 14 sheets of drawing illustrating actual fixture details for vertical thermal element 31, source holder 34, rods 36 and ancillary components.

As will now be apparent, the invention permits in-situ diffusion of dopant materials into one or both major surfaces of the growing dendritic web emerging from the melt crucible. This arrangement eliminates the necessity for providing gaseous dopant diffusion sources and the attendant disadvantages of such diffusion source arrangements. IN addition, the solid planar diffusion source may be easily installed and removed from the source holder, and the relative vertical position of the solid diffusion source 33 can be readily adjusted by means of rods 36 to provide source temperature adjustment. Perhaps most importantly, the invention eliminates the need for a separate diffusion station for the dendritic web formation process, which renders the production facility more compact and simplifies the installation, initial set-up and process operation when producing dendritic web photovoltaic cells.

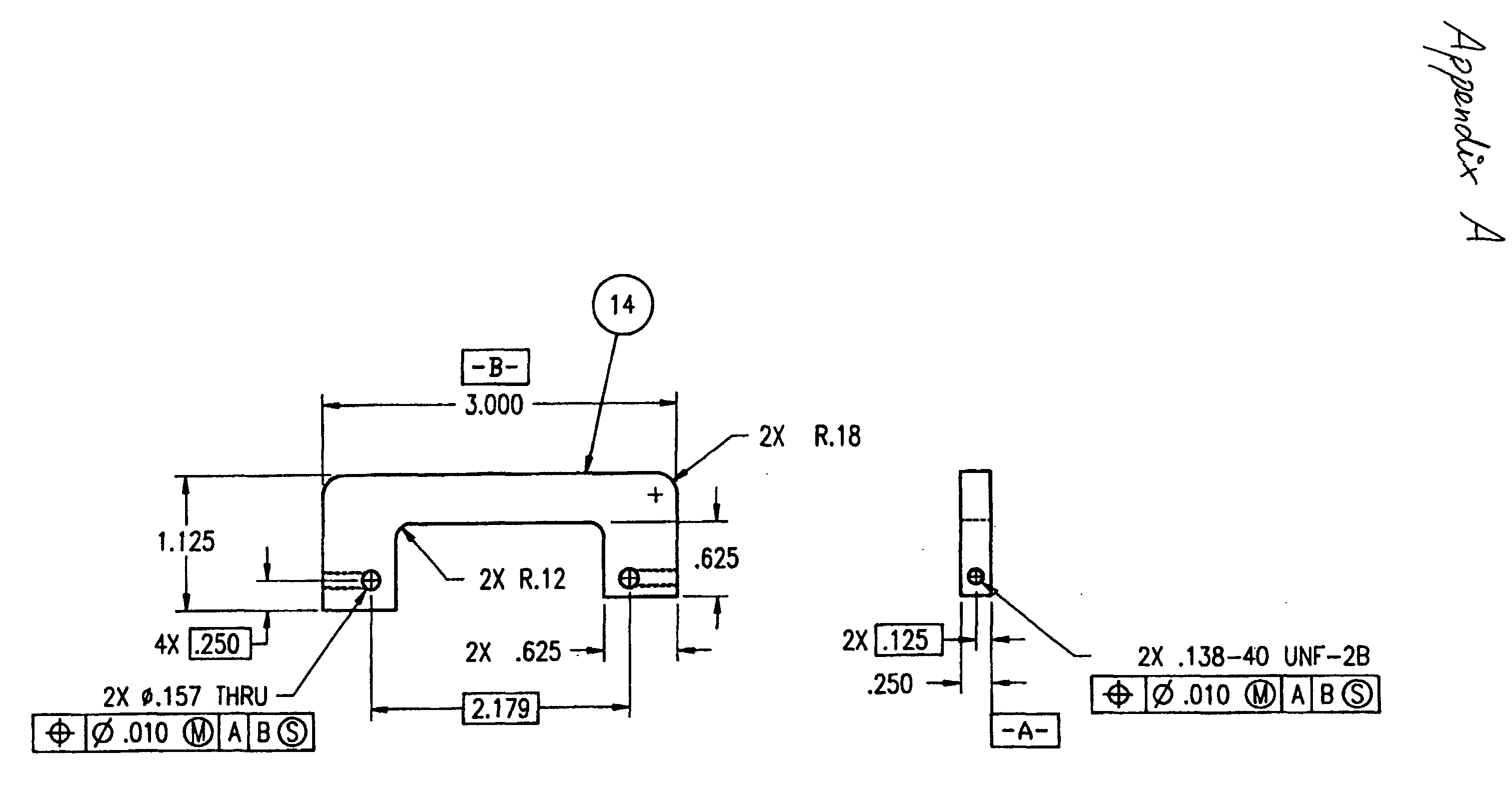

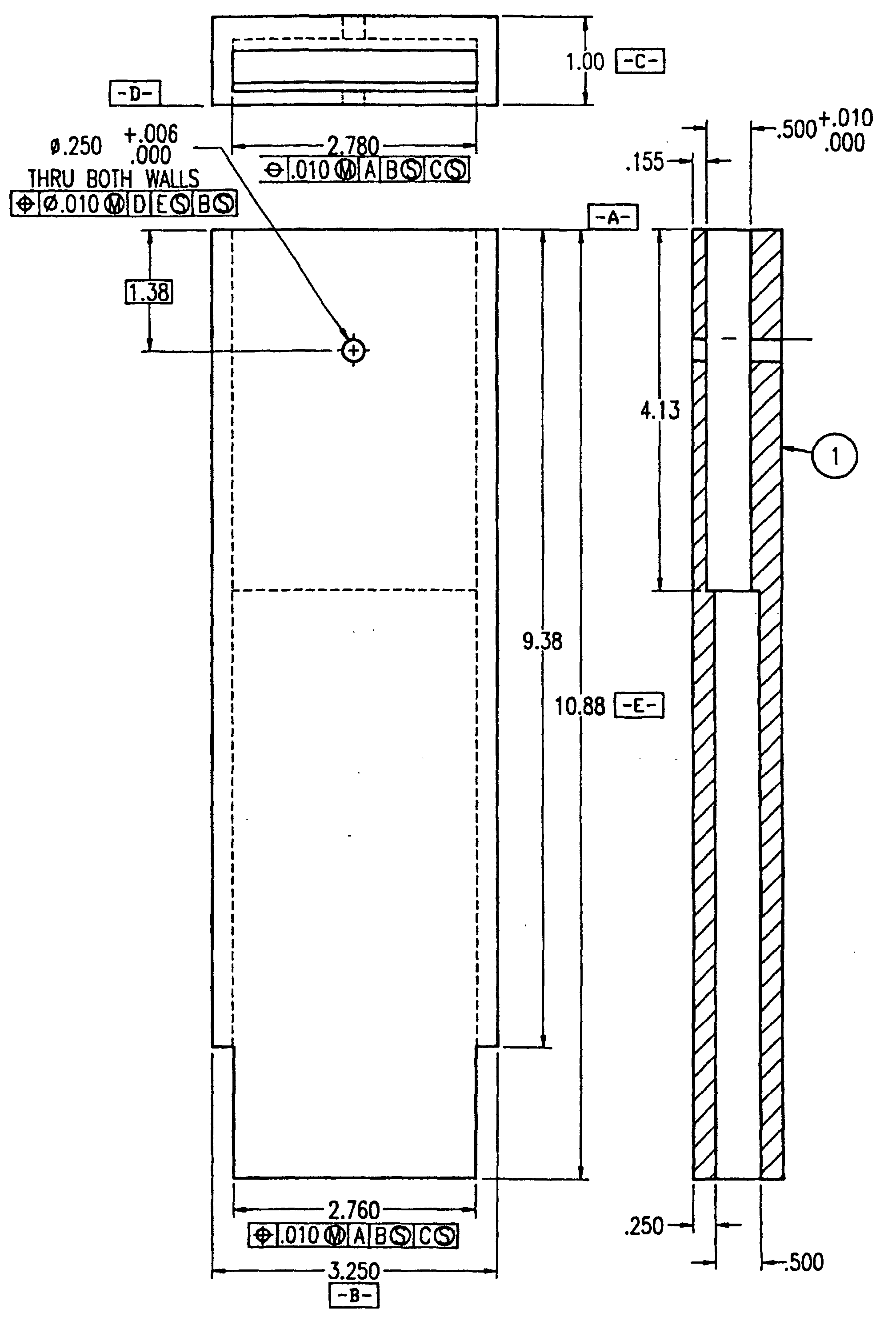

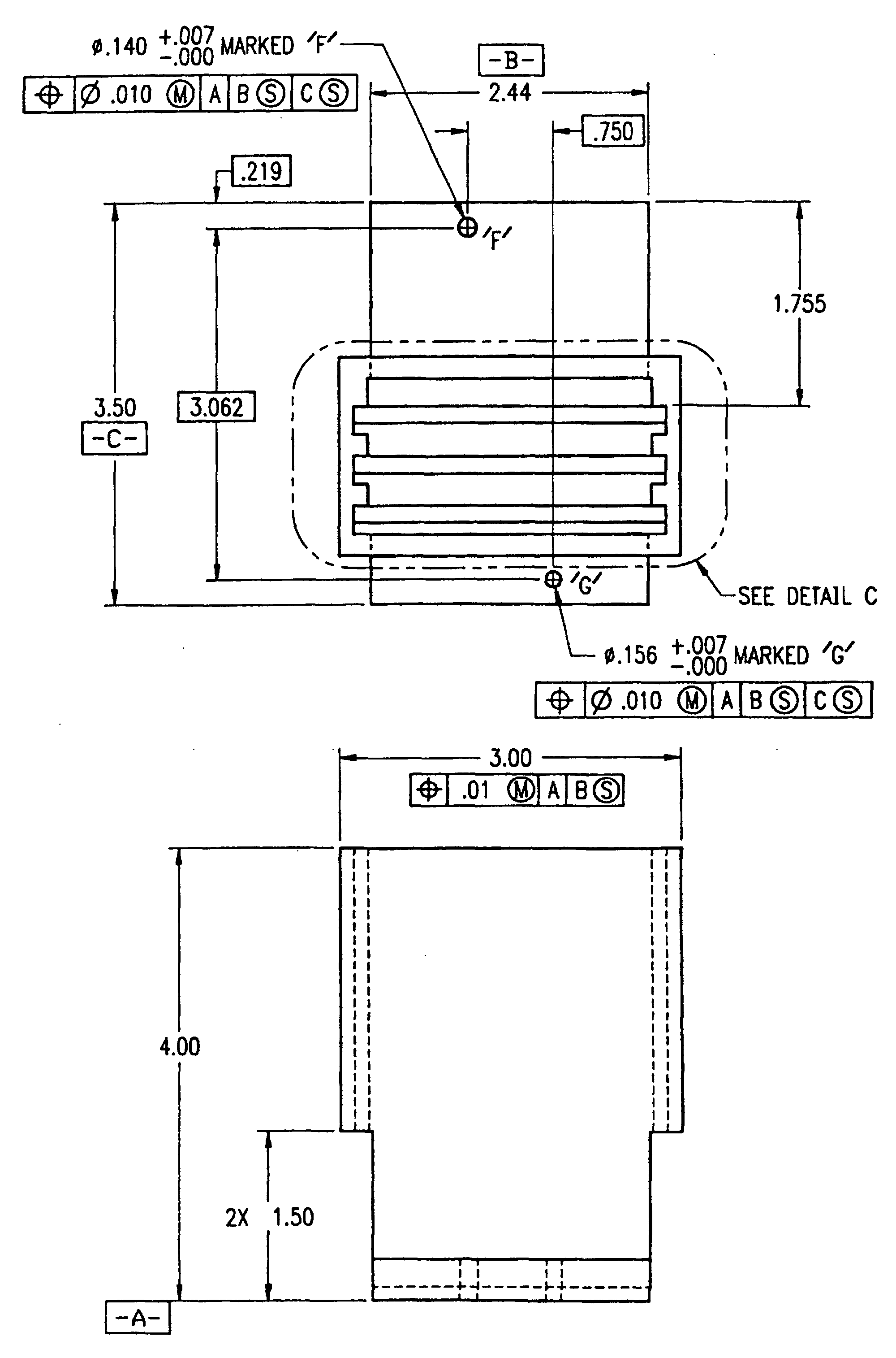

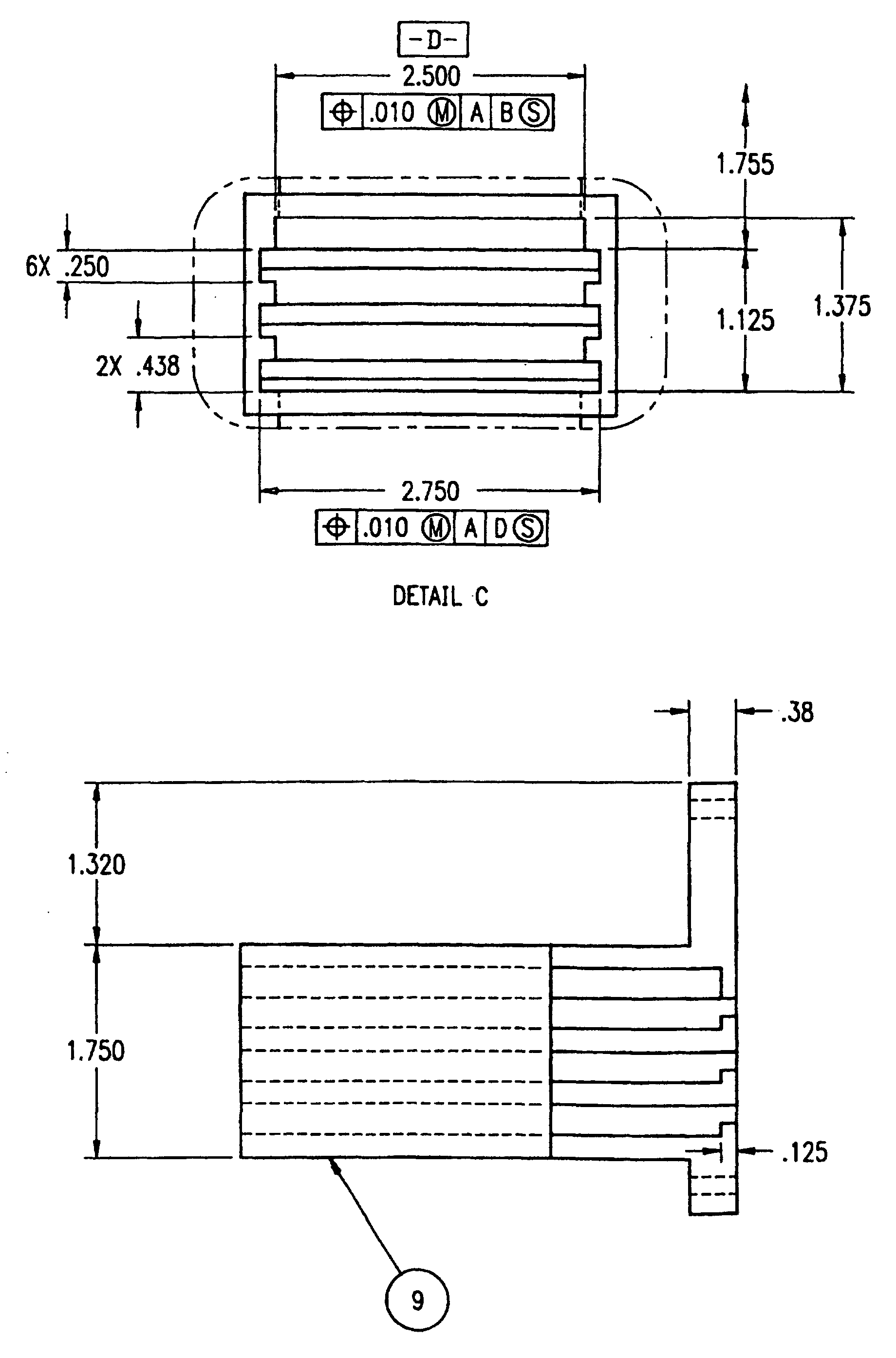

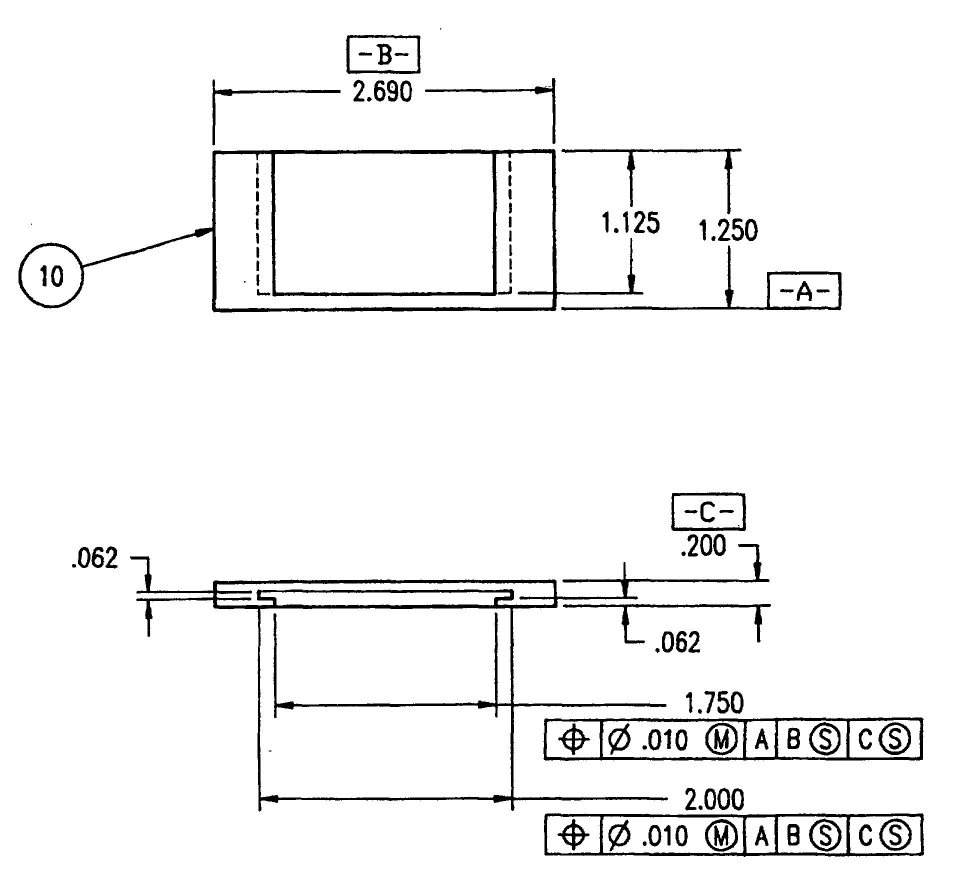

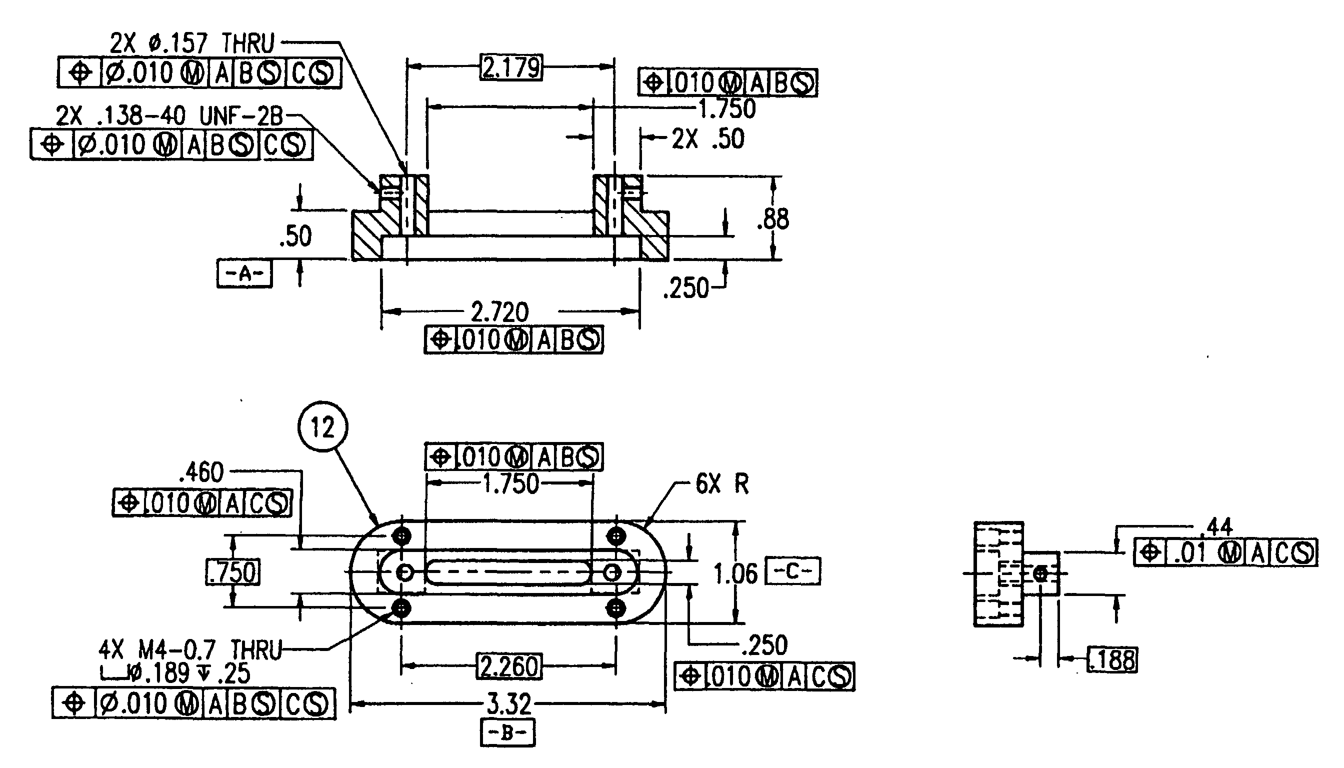

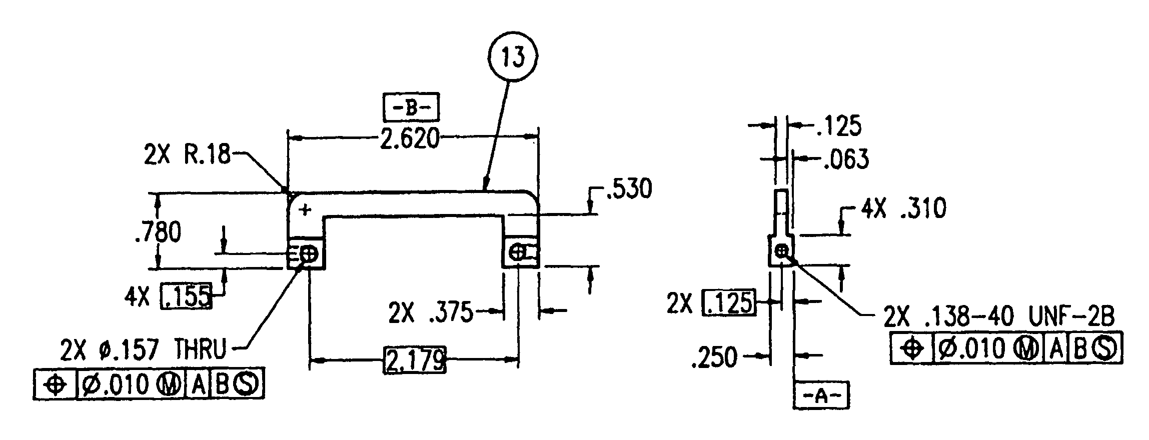

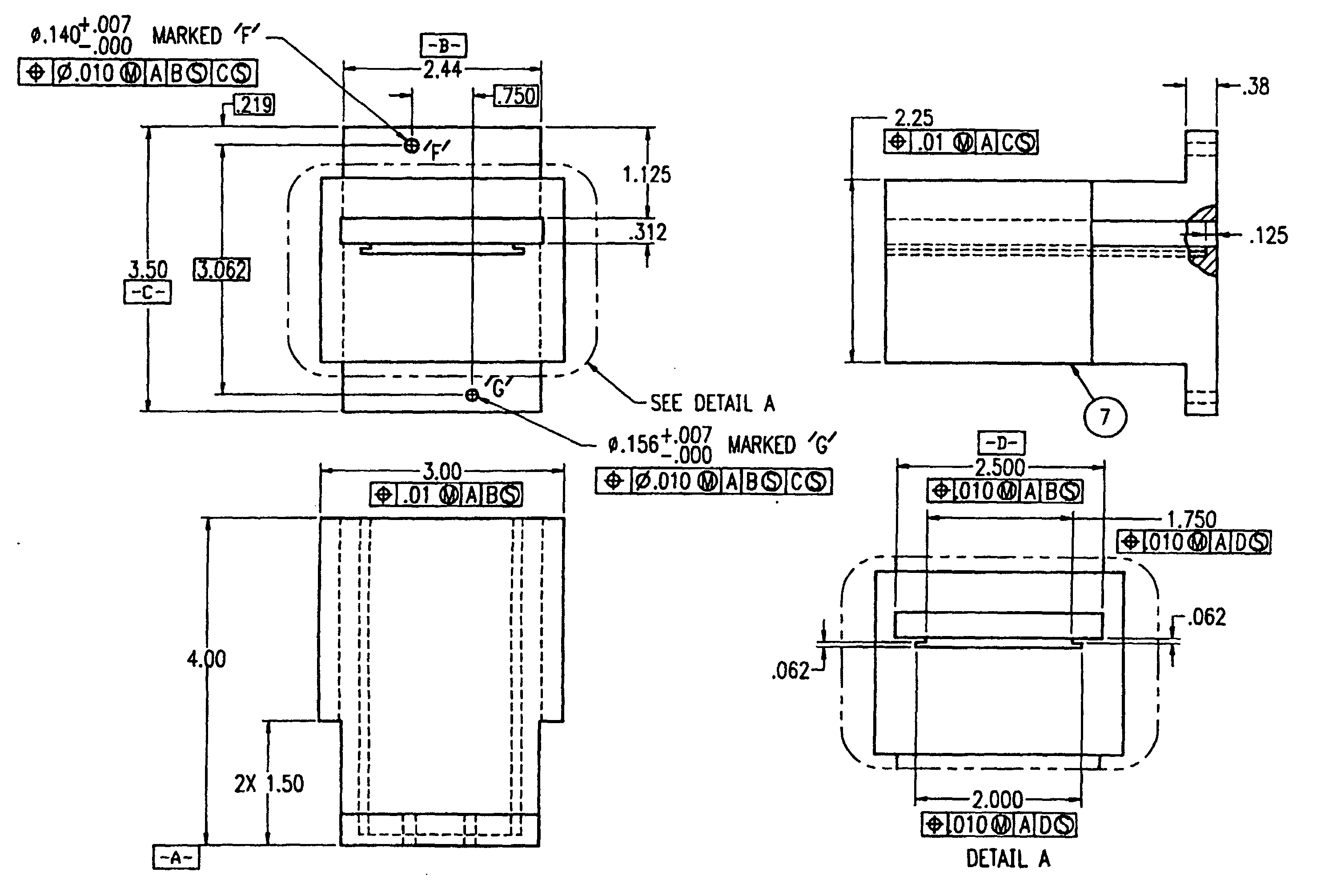

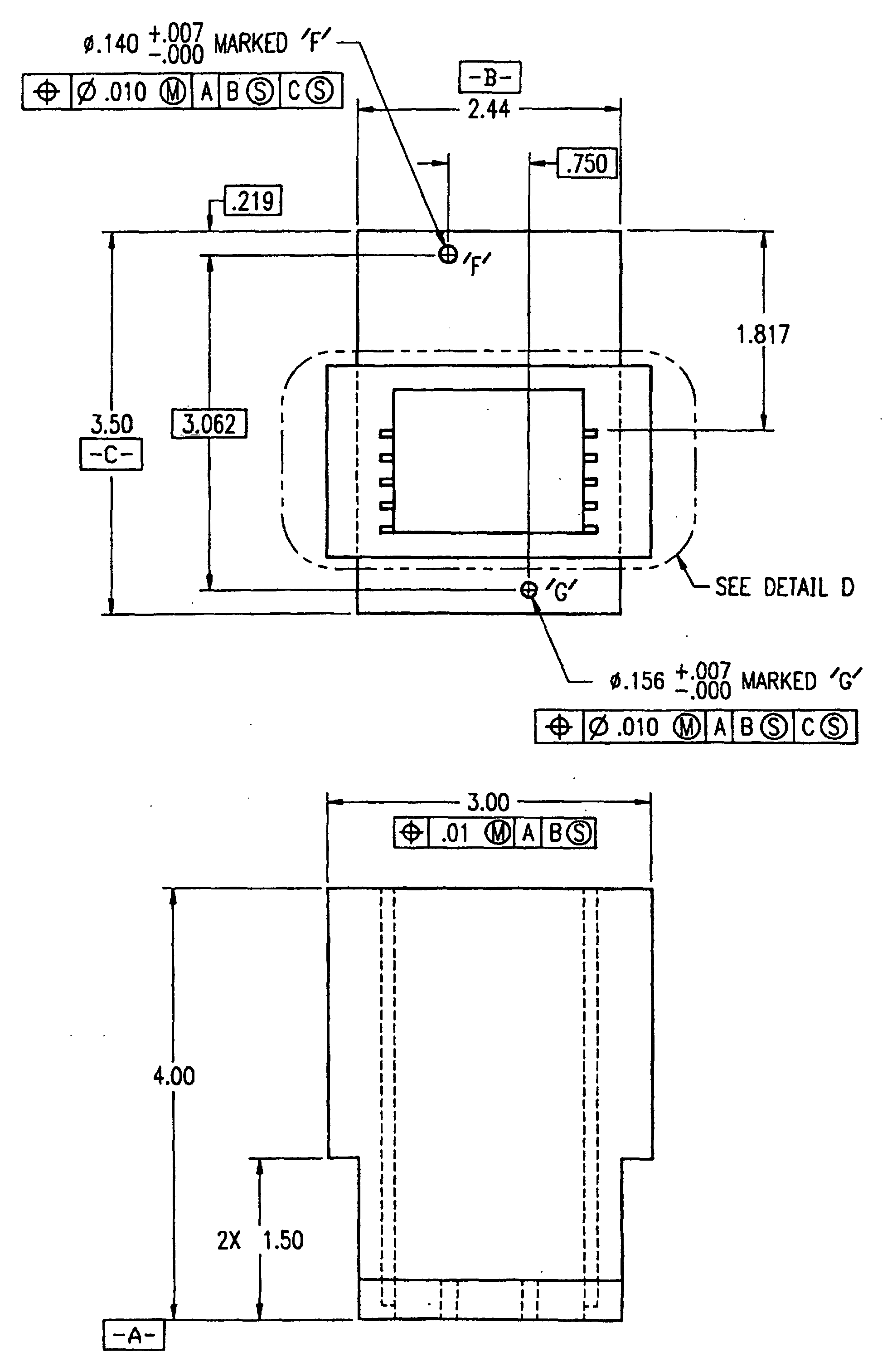

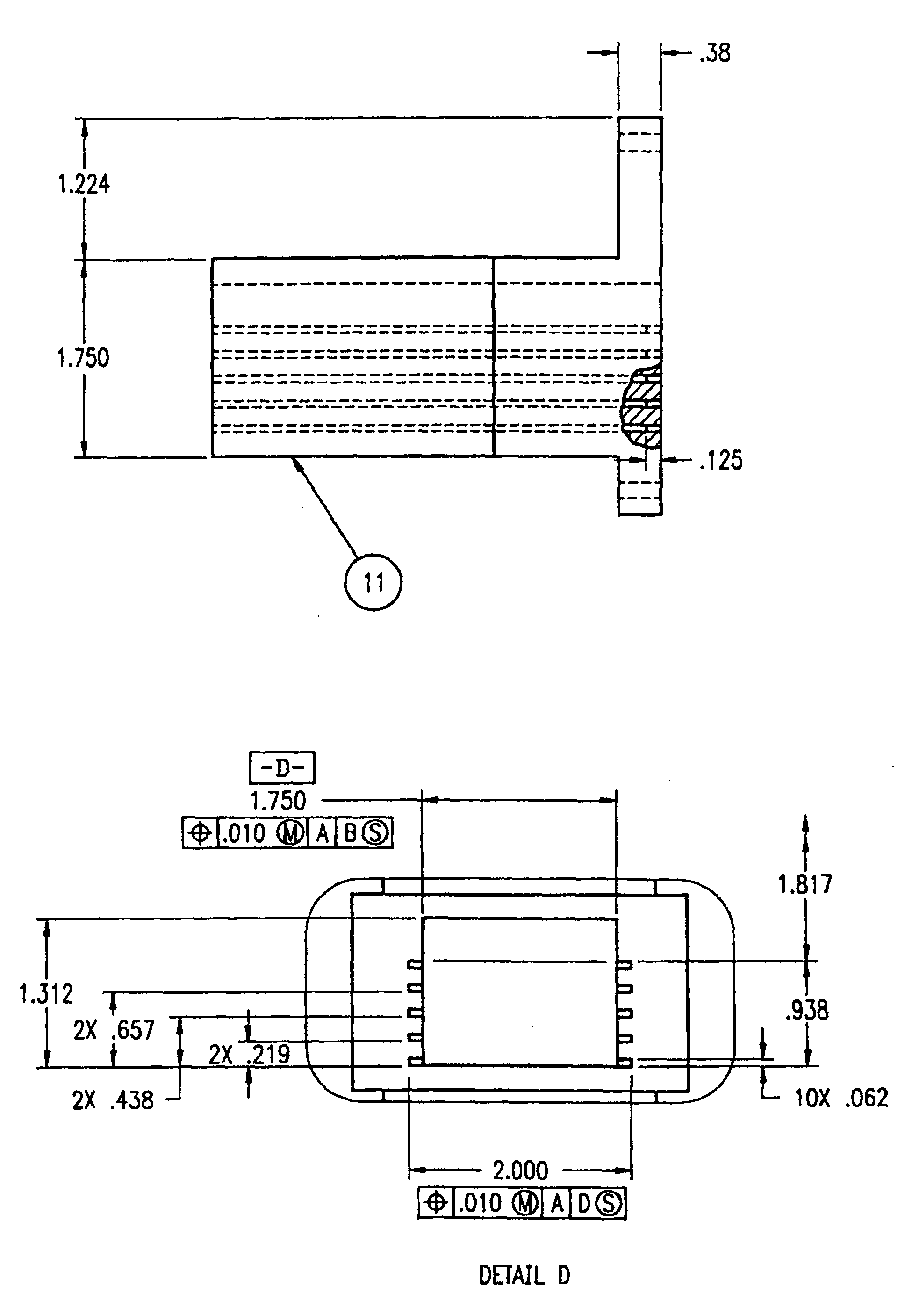

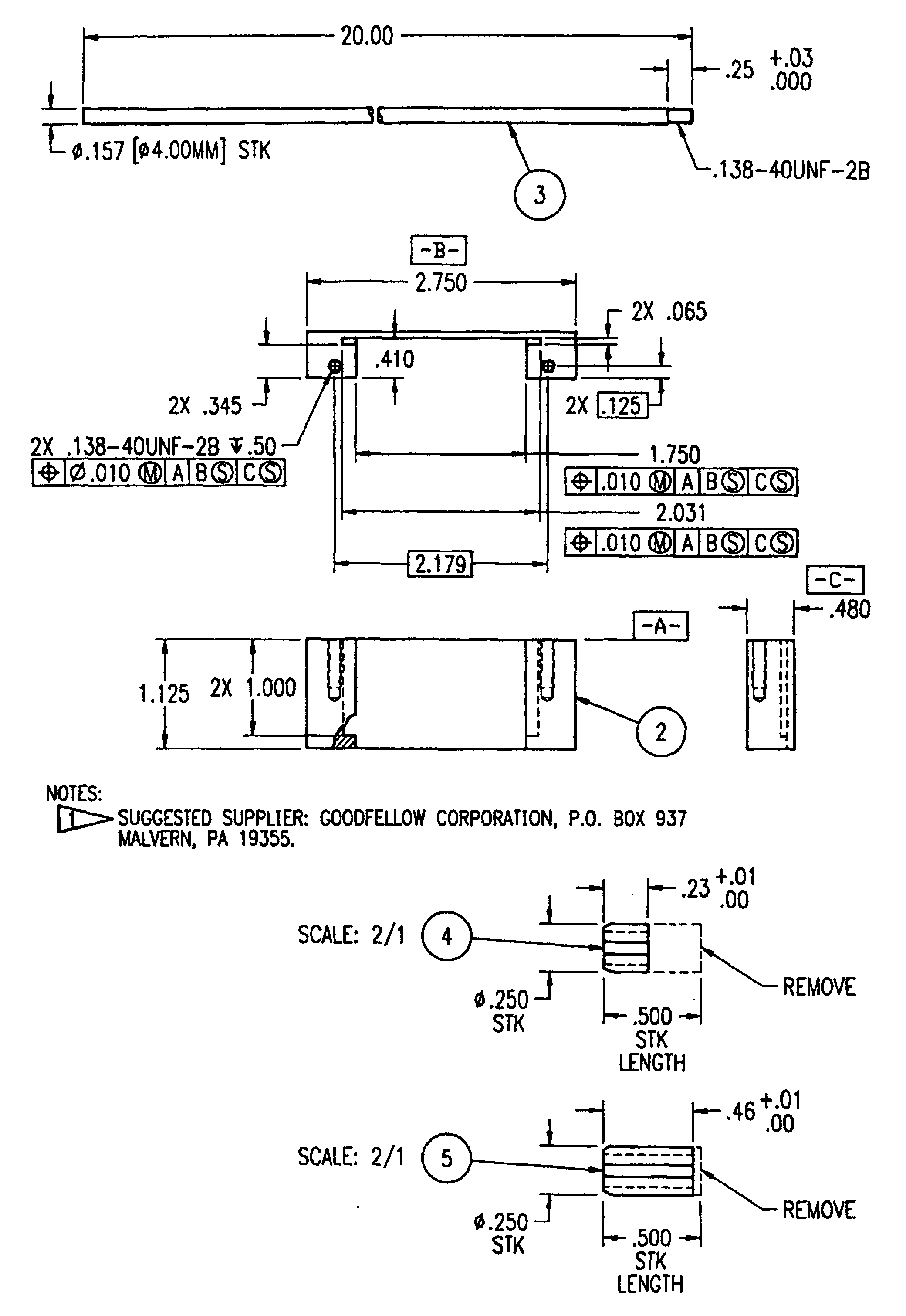

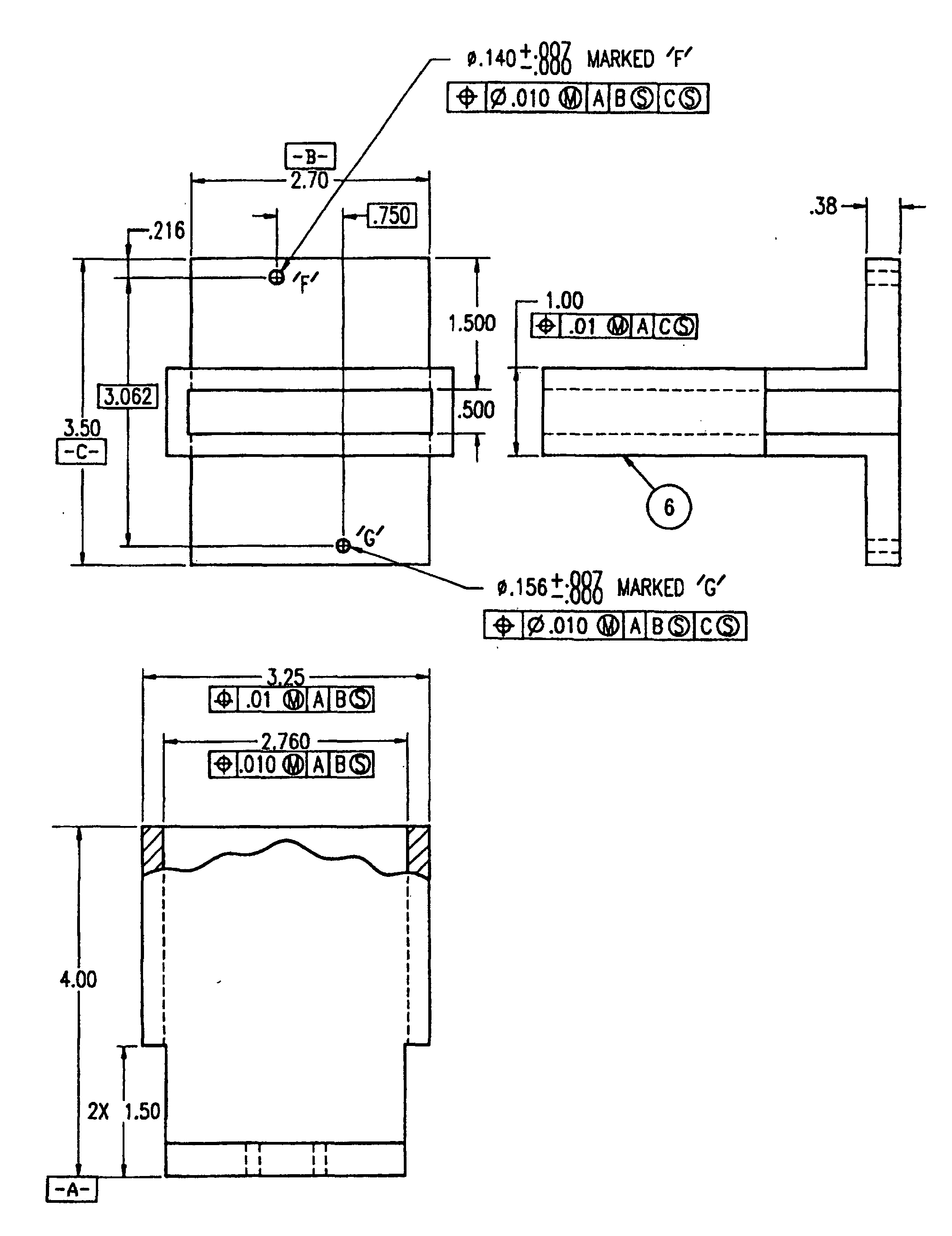

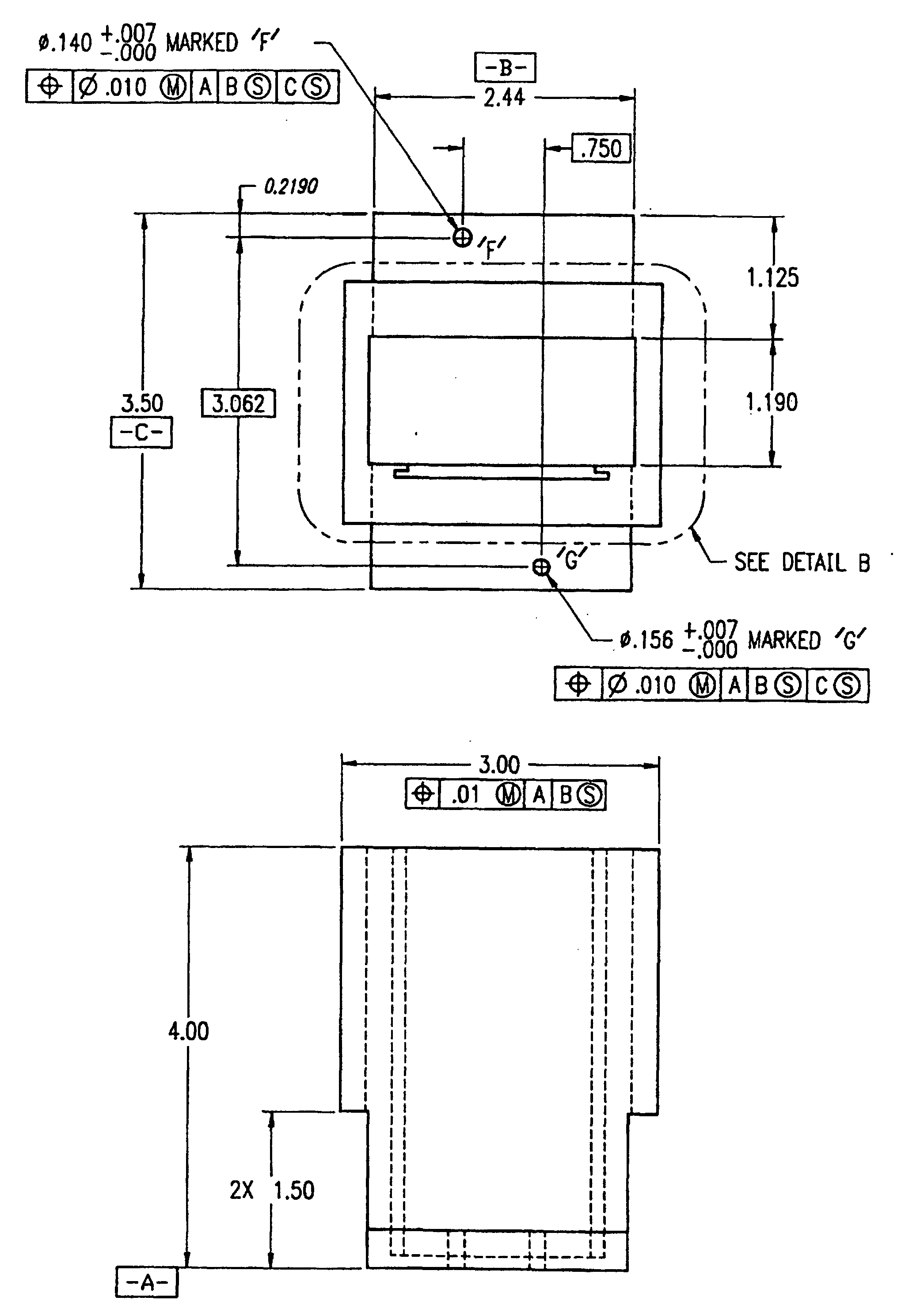

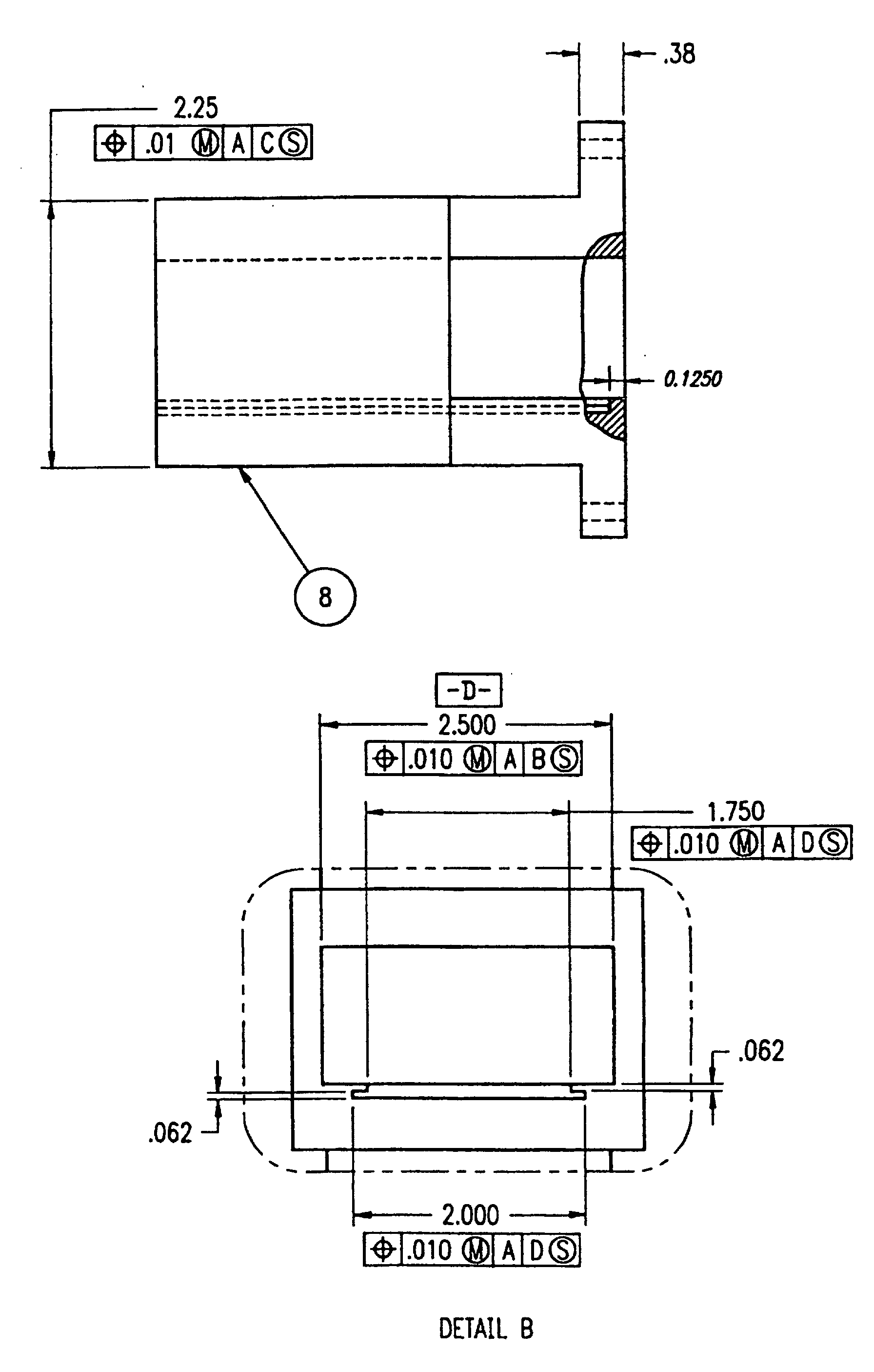

## Claims

1. A method of fabricating a dendritic web silicon photovoltaic crystal ribbon, comprising the steps of:
(1) growing a dendritic web silicon crystal ribbon including two major surfaces and a dendrite from a melt source in a furnace by drawing melt material along a path from the melt source and permitting the melt material to cool; and
(2) directly exposing both major surfaces of the growing web to a a solid dopant material having planar form heated to a diffusion temperature as the growing web is drawn along the path,
wherein the planar solid dopant material partially extends along the length of the ribbon, wherein the solid dopant material comprises a first dopant material element arranged in facing relation to one of said first and second major surfaces of said dendritic crystal web, and a second dopant material element arranged in facing relation to the other one of said first and second major surfaces of said dendritic crystal web so that each of said first and second dopant material elements functions as a diffusion source for the corresponding facing major surface of said growing dendritic crystal web wherein said first and second dopant material elements provide dopants of opposite conductivity types.

2. The method of claim 1 wherein said step (2) of exposing includes the step of placing a solid dopant material in a holder adjacent a thermal source, to heat the solid dopant material to the diffusion temperature.

3. The method of claim 2 wherein said step of placing includes the steps of providing a solid thermal element and heating the thermal element.

4. The method of claim 3 wherein said step of heating is performed by subjecting the thermal element to heat contained in the furnace.

5. The method of claim 3 wherein said step of heating is performed by heating the thermal element with a heating coil.

6. The method of claim 1 wherein said step (2) of exposing is performed within the furnace.

7. The method of claim 1 wherein the furnace has a web exit port; and wherein said step (2) of exposing is performed outside the furnace.

8. The method of claim 7 wherein said step (2) of exposing includes the steps of providing a thermal source adjacent the exit port, and placing the solid dopant material in thermal contact with the thermal source adjacent the exit port.

9. An apparatus for fabricating a dendritic web silicon photovoltaic crystal ribbon, said apparatus comprising:
a furnace having means for producing a melt source of silicon crystal growing material, and an exit port;
means for drawing melt material along a path from the melt source through the exit port so that a dendritic web silicon crystal ribbon including two major surfaces and a dendrite is grown as the melt material is drawn along the path;
a solid dopant material arranged along said path, said solid dopant material having planar form and being maintained in facing relation to both major surfaces of said dendritic Si crystal web, wherein the planar solid dopant material partially extends along the length of the ribbon, wherein the solid dopant material comprises a first dopant material element arranged in facing relation to one of said first and second major surfaces of said dendritic crystal web, and a second dopant material element arranged in facing relation to the other one of said first and second major surfaces of said dendritic crystal web so that each of said first and second dopant material elements functions as a diffusion source for the corresponding facing major surface of said growing dendritic crystal web wherein said first and second dopant material elements provide dopants of opposite conductivity types; and
means for heating said solid dopant material to a diffusion temperature so that the growing dendritic crystal web is exposed to said solid dopant material in order to create a diffusion layer in said at least one of said two major surfaces.

10. The apparatus of claim 9 further including a holder mounted along the path for receiving said solid dopant material.

11. The apparatus of claim 10 wherein said holder is located within said furnace.

12. The apparatus of claim 10 wherein said holder is located outside said furnace adjacent said exit port.

13. The apparatus of claim 9 wherein said means for heating said solid dopant material includes a thermal element located along said path and at least partially surrounding said dopant material, said solid dopant material being arranged in thermal contact with said thermal element.

14. The apparatus of claim 13 wherein said means for heating said thermal element further includes a heating coil for heating said thermal element.

15. The apparatus of claim 13 wherein said means for heating is located within said furnace.

16. The apparatus of claim 13 wherein said means for heating is located outside said furnace adjacent said exit port.

17. The method of claim 1 wherein said solid dopant material is a rectangular strip.

18. The apparatus of claim 9 wherein said solid dopant material is a rectangular strip.

## Patentansprüche

1. Verfahren zum Herstellen einer dendritischen Matrix eines fotovoltaischen Siliziumkristallbandes, umfassend die Schritte des:
(1) Züchtens eines Siliziumkristallbandes einer dendritischen Matrix, welches zwei Hauptoberflächen aufweist und einen Dendriten aus einer Schmelzquelle in einem Ofen durch Ziehen des Schmelzmaterials entlang eines Pfades von der Schmelzquelle und Erlauben, dass das Schmelzmaterial abkühlt; und
(2) direktes Exponieren beider Hauptoberflächen der wachsenden Matrix gegenüber einem Festkörper-Dotiermaterial, welches eine planare Form aufweist, welches auf eine Diffusionstemperatur aufgeheizt ist, während die wachsende Matrix entlang des Pfades gezogen wird,
wobei sich das planare Festkörper-Dotiermaterial teilweise entlang der Länge des Bandes erstreckt, wobei das Festkörper-Dotiermaterial ein erstes Dotiermaterial-Element, welches in gegenüberliegender Beziehung zu den ersten und zweiten Hauptoberflächen der dendritischen Kristallmatrix angeordnet ist, und ein zweites Dotiermaterial-Element umfasst, welches in gegenüberliegender Beziehung zu der anderen der ersten und zweiten Hauptoberflächen der dendritischen Kristallmatrix angeordnet ist, so dass jedes der ersten und zweiten Dotiermaterial-Elemente als Diffusionsquelle für die entsprechende gegenüberliegende Hauptoberfläche der wachsenden dendritischen Kristallmatrix wirkt.

2. Verfahren gemäß Anspruch 1, wobei der Schritt (2) des Aussetzens den Schritt des Platzierens eines Festkörper-Dotiermaterials in einem Halter angrenzend der Wärmequelle enthält, um das Festkörper-Dotiermaterial auf die Diffusionstemperatur aufzuheizen.

3. Verfahren gemäß Anspruch 2, wobei der Schritt des Platzierens die Schritte des Vorsehens eines festen Thermo-Elements und des Aufheizens des Thermo-Elements enthält.

4. Verfahren gemäß Anspruch 3, wobei der Schritt des Aufheizens durchgeführt wird durch Unterwerfen des Thermo-Elements einer Wärme, die in dem Ofen enthalten ist.

5. Verfahren gemäß Anspruch 3, wobei der Schritt des Aufheizens durchgeführt wird durch Aufheizen des Thermo-Elements mit einer Heizspule.

6. Verfahren gemäß Anspruch 1, wobei der Schritt (2) des Aussetzens innerhalb des Ofens durchgeführt wird.

7. Verfahren gemäß Anspruch 1, wobei der Ofen eine Matrixausgangsöffnung aufweist; und wobei der Schritt (2) des Aussetzens außerhalb des Ofens durchgeführt wird.

8. Verfahren gemäß Anspruch 7, wobei der Schritt (2) des Aussetzens die Schritte des Vorsehens einer Wärmequelle angrenzend der Ausgangsöffnung enthält und des Platzierens des Festkörper-Dotiermaterials in einem thermischen Kontakt mit der Wärmequelle angrenzend der Ausgangsöffnung.

9. Vorrichtung zum Herstellen eines fotovoltaischen Siliziumkristallbandes einer dendritischen Matrix, wobei die Vorrichtung umfasst:
einen Ofen, der Mittel zum Herstellen einer Schmelzquelle des wachsenden Materials des Siliziumkristalls aufweist und eine Ausgangsöffnung;
Mittel zum Ziehen eines Schmelzmaterials entlang eines Pfades aus der Schmelzquelle durch die Ausgangsöffnung, so dass ein Siliziumkristallband einer dendritischen Matrix, die zwei Hauptoberflächen enthält und ein Dendrit gezüchtet wird, während das Schmelzmaterial entlang des Pfades gezogen wird;
ein Festkörper-Dotiermaterial, das entlang des Pfades angeordnet ist, wobei das Festkörper-Dotiermaterial eine planare Form aufweist und in gegenüberliegender Beziehung zu beiden Hauptoberflächen der dendritischen Siliziumkristallmatrix gehalten wird, wobei das planare Festkörper-Dotiermaterial sich im Wesentlichen entlang der Länge des Bandes erstreckt, wobei das Festkörper-Dotiermaterial ein erstes Dotiermaterialelement umfasst, das in gegenüberliegender Beziehung zu entweder der ersten oder der zweiten Hauptoberfläche der dendritischen Kristallmatrix angeordnet ist und ein zweites Dotiermaterialelement, das in gegenüberliegender Beziehung zu der anderen der ersten und zweiten Hauptoberflächen der dendritischen Kristallmatrix angeordnet ist, so dass jedes der ersten und zweiten Dotiermaterialelemente als Diffusionsquelle für die entsprechende gegenüberliegende Hauptoberfläche der wachsenden dendritischen Kristallmatrix wirkt;
wobei die ersten und zweiten Dotiermaterial-Elemente Dotierstoffe entgegengesetzter Leitfähigkeits-Typen vorsehen; und
wobei die Mittel zum Aufheizen außerhalb des Ofens angrenzend der Ausgangsöffnung platziert sind; und
Mittel zum Aufheizen des Festkörper-Dotiermaterials auf eine Diffusionstemperatur, so dass die wachsende dendritische Kristallmatrix dem Festkörper-Dotiermaterial ausgesetzt wird, um eine Diffusionsschicht in zumindest einer der zwei Hauptoberflächen zu bilden.

10. Vorrichtung gemäß Anspruch 9, welche weiterhin einen Halter enthält, der entlang des Pfades montiert ist zum Aufnehmen des Festkörper-Dotiermaterials.

11. Vorrichtung gemäß Anspruch 10, wobei der Halter innerhalb des Ofens platziert ist.

12. Vorrichtung gemäß Anspruch 10. wobei der Halter außerhalb des Ofens angrenzend der Ausgangsöffnung platziert ist.

13. Vorrichtung gemäß Anspruch 9, wobei die Mittel zum Aufheizen des Festkörper-Dotiermaterials ein Thermoelement enthalten, das entlang des Pfades platziert ist und zumindest teilweise das Dotiermaterial umgibt, wobei das Festkörper-Dotiermaterial in thermischem Kontakt mit dem Thermoelement angeordnet ist.

14. Vorrichtung gemäß Anspruch 13, wobei die Mittel zum Aufheizen des Thermoelements weiterhin eine Heizspule zum Aufheizen des Thermoelements enthalten.

15. Vorrichtung gemäß Anspruch 13, wobei die Mittel zum Aufheizen innerhalb des Ofens platziert sind.

16. Vorrichtung gemäß Anspruch 13, wobei die Mittel zum Aufheizen außerdem des Ofens angrenzend der Ausgangsöffnung platziert sind.

17. Verfahren gemäß Anspruch 1, wobei das Festkörper-Dotiermaterial ein rechteckiger Streifen ist.

18. Vorrichtung gemäß Anspruch 9, wobei das Festkörper-Dotiermaterial ein rechteckiger Streifen ist.

## Revendications

1. Procédé pour fabriquer un ruban de cristal de silicium photovoltaïque à bande dendritique, comprenant les étapes consistant à:
(1) faire croître un ruban de cristal de silicium à bande dendritique incluant deux surfaces principales et une dendrite délivrée par une source de masse fondue dans un four par tirage du matériau fondu le long d'un trajet partant de la source de fusion et permettant un refroidissement du matériau fondu;
(2) exposer directement les deux surfaces principales de la bande en cours de croissance à un matériau dopant solide possédant une forme plane et chauffé à une température de diffusion lorsque la bande en cours de croissance est tirée le long du trajet, et selon lequel le matériau dopant solide plat s'étend partiellement sur la longueur du ruban, et selon lequel le matériau dopant solide comprend un premier élément de matériau dopant disposé de manière à être en vis-à-vis de l'une desdites première et seconde surfaces principales de ladite bande de cristal dendritique et un second élément de matériau dopant disposé de manière à être situé en vis-à-vis de l'autre desdites première et seconde surfaces principales de ladite bande de cristal dendritique de sorte que chacun des premier et second éléments du matériau dopant agit en tant que source de diffusion pour la surface principale, tournée en vis-à-vis de façon correspondante de ladite bande de cristal dendritique en cours de croissance, les premier et second éléments de matériau dopant fournissant des dopants ayant des types de conductivité opposés.

2. Procédé selon la revendication 1, selon lequel ladite étape d'exposition (2) inclut l'étape constituant à placer un matériau dopant solide dans un dispositif de retenue adjacent à une source thermique pour chauffer le matériau dopant solide jusqu'à la température de diffusion.

3. Procédé selon la revendication 2, dans lequel ladite étape de mise en place inclut les étapes consistant à prévoir un élément thermique solide et à chauffer l'élément thermique.

4. Procédé selon la revendication 3, selon lequel ladite étape de chauffage est effectuée en soumettant l'élément thermique à une chaleur contenue dans le four.

5. Procédé selon la revendication 3, selon lequel ladite étape de chauffage est exécutée en chauffant l'élément thermique avec une bobine de chauffage.

6. Procédé selon la revendication 1, selon lequel ladite étape d'exposition (2) est exécutée dans le four.

7. Procédé selon la revendication 1, selon lequel le four comporte un orifice de sortie de la bande; et selon lequel ladite étape d'exposition (2) est exécutée à l'extérieur du four.

8. Procédé selon la revendication 7, selon lequel ladite étape d'exposition (2) inclut des étapes consistant. à disposer une source thermique au voisinage de l'orifice de sortie et à placer le matériau dopant solide en contact thermique avec la source thermique au voisinage de l'orifice de sortie.

9. Dispositif pour la fabrication d'un ruban de cristal de silicium photovoltaïque à bande dendritique, ledit dispositif comprenant:
un four comportant des moyens pour produire une source de masse fondue du matériau de croissance de cristal de silicium, et un orifice de sortie;
des moyens pour tirer ledit matériau fondu le long d'un trajet partant de la source de fusion à travers l'orifice de sortie de sorte qu'il se produit une croissance du ruban de cristal de silicium à bande dendritique incluant deux surfaces principales et une dendrite lorsque le matériau fondu est tiré le long du trajet;
un matériau dopant solide disposé le long dudit trajet, ledit matériau dopant solide possédant une forme et étant maintenu en vis-à-vis des deux surfaces principales de la bande de cristal de Si dendritique, et dans lequel le matériau dopant solide comprend un premier élément de matériau dopant disposé de manière à être en vis-à-vis de l'une desdites première et seconde surfaces principales de ladite bande de cristal dendritique et un second élément de matériau dopant disposé de manière à être situé en vis-à-vis de l'autre desdites première et seconde surfaces principales de ladite bande de cristal dendritique de sorte que chacun des premier et second éléments du matériau dopant agit en tant que source de diffusion pour la surface principale, tournée en vis-à-vis de façon correspondante de ladite bande de cristal dendritique en cours de croissance, les premier et second éléments de matériau dopant fournissant des dopants ayant des types de conductivité opposés; et
des moyens pour chauffer ledit matériau dopant solide à une température de diffusion de telle sorte que la bande de cristal dendritique en cours de croissance est exposée audit matériau dopant solide pour créer une couche de diffusion dans ladite au moins une desdites deux surfaces principales.

10. Dispositif selon la revendication 9, comprenant en outre un dispositif de retenue monté le long du trajet pour recevoir ledit matériau dopant solide.

11. Dispositif selon la revendication 10, dans lequel ledit dispositif de retenue est situé dans ledit four.

12. Dispositif selon la revendication 10, dans lequel ledit dispositif de retenue est situé à l'extérieur dudit four au voisinage dudit orifice de sortie.

13. Dispositif selon la revendication 9, dans lequel lesdits moyens de chauffage dudit matériau dopant solide incluent un élément thermique situé le long dudit trajet et entourant au moins partiellement ledit matériau dopant, ledit matériau dopant solide étant disposé en contact thermique avec ledit élément thermique.

14. Dispositif selon la revendication 13, dans lequel lesdits moyens pour chauffer ledit élément thermique comporte en outre une bobine de chauffage pour chauffer ledit élément thermique.

15. Dispositif selon la revendication 13, dans lequel lesdits moyens de chauffage sont situés dans ledit four.

16. Dispositif selon la revendication 13, dans lequel lesdits moyens de chauffage sont situés à l'extérieur dudit four au voisinage dudit orifice de sortie.

17. Procédé selon la revendication 1, selon lequel ledit matériau dopant solide est une bande rectangulaire.

18. Dispositif selon la revendication 9, dans lequel ledit matériau dopant solide est une bande rectangulaire.
